# DEMANDE DE BREVET EUROPEEN

(11) **EP 0 601 927 A1**
(43) Date de publication de la demande: **15.06.1994**
(21) Numéro de dépôt: 93402954.7
(22) Date de dépôt: 07.12.1993
(51) Int. Cl.: H03H 7/01

(54) **Etage de sortie d'un circuit électrique**

(30) Priorité: 11.12.1992 FR 9214951
(71) Demandeur: THOMSON-CSF SEMICONDUCTEURS SPECIFIQUES, 75008 Paris (FR)
(72) Inventeur: Pataut, Gérard, F-92402 Courbevoie Cedex (FR); Dietsche, Stéfan, F-92402 Courbevoie Cedex (FR)
(74) Mandataire: Guérin, Michel

(57) **Abrégé**

L'invention concerne un étage d'adaptation ou de réjection de fréquences en sortie d'un circuit électronique travaillant à au moins trois fréquences.

Ce circuit comprend normalement des réseaux d'adaptation et de réjection (C₁ L₁, C₂ L₂), qui sont calculés pour correspondre, chacun, à une fréquence donnée (F1, F3). Selon l'invention, au moins deux réseaux (C₁ L₁, C₂ L₂) sont combinés pour que leur combinaison corresponde à une troisième fréquence (F2).

Application aux circuits hyperfréquences.

## Description

La présente invention concerne l'étage de sortie d'un circuit électronique comportant, en sortie, au moins un réseau d'adaptation, en impédance par exemple, et un réseau de réjection de fréquences. Selon l'invention, au moins deux de ces réseaux, correspondant à deux fréquences, sont calculés pour que leur combinaison corresponde à un troisième réseau d'adaptation ou de réjection, à une fréquence différente des deux fréquences précédentes.

Ces problèmes de fréquences se posent fréquemment, surtout dans le domaine des micro-ondes (1 à 100 GHz), parce qu'une fréquence élevée n'est pratiquement jamais générée seule. Soit un oscillateur fournit une fréquence fondamentale, pour laquelle il a été calculé, mais il fournit alors aussi des fréquences parasites telles que les harmoniques 2 et 3. Soit au contraire un mélangeur reçoit une pluralité de signaux à différentes fréquences, qui sont ou ne sont pas en relation harmonique. De sorte qu'il est fréquent qu'un circuit électronique comporte en sortie au moins un réseau de réjection pour une fréquence indésirable, mais aussi plusieurs réseaux pour plusieurs fréquences.

En outre, et plus particulièrement aux hautes fréquences, les opérations effectuées sur un signal électrique peuvent en changer l'impédance, de sorte que chaque circuit comprend en sortie un réseau d'adaptation d'impédance, pour conserver celle-ci constante tout le long de la chaîne de traitement du signal.

Les méthodes connues et habituellement utilisées consistent à monter autant de réseaux qu'il y a de fréquences présentes, sans associer ces réseaux, ce qui conduit à des circuits plus complexes, occupant une surface plus importante et ayant plus de pertes puisqu'il y a plus de composants.

Or, dans les micro-ondes, il est important d'avoir les circuits les plus simples et les plus compacts possibles, afin d'éviter les déphasages dûs aux lignes, les variations d'impédance dues aux composants ou tous autres inconvénients liés aux micro-ondes. De plus, il est bon que les solutions proposées soient homogènes en technologie avec celle qui est utilisée pour réaliser le circuit micro-onde : dans le cas de l'invention, il s'agit de la technologie circuits intégrés, sur silicium ou matériaux dits "III-V" tel que GaAs.

Selon l'invention, l'étage de sortie d'un circuit micro-ondes combine au moins deux réseaux, montés en série et/ou en parallèle, de type Teschbichev, elliptique ou autres, ayant une fonction d'adaptation ou de réjection de deux premières fréquences, pour réaliser un troisième réseau ayant une propriété recherchée à une troisième fréquence.

De façon plus précise, l'invention concerne un étage de sortie d'un circuit électronique travaillant à au moins trois fréquences et comportant au moins un réseau d'adaptation et un réseau de réjection, cet étage de sortie étant caractérisé en ce que au moins deux réseaux calculés pour correspondre chacun séparément à une fréquence de travail, donnent dans leur combinaison l'équivalant d'un troisième réseau qui correspond à une troisième fréquence.

L'invention sera mieux comprise par la description suivante de deux exemples d'application, appuyée sur les figures jointes en annexe, qui représentent :
- figure 1 : schéma électrique d'un étage de sortie selon l'invention ;
- figure 2 : schéma d'un mélangeur à diode muni d'un étage de sortie selon l'invention ;
- figures 3 et 4 : diagrammes montrant les spectres en sortie d'un mélangeur sans étage de sortie (figure 3) et avec étage de sortie (figure 4) ;
- figure 5 : schéma d'un amplificateur muni d'un étage de sortie selon l'invention ;
- figure 6 : courbe de rendement de l'amplificateur de la figure précédente.

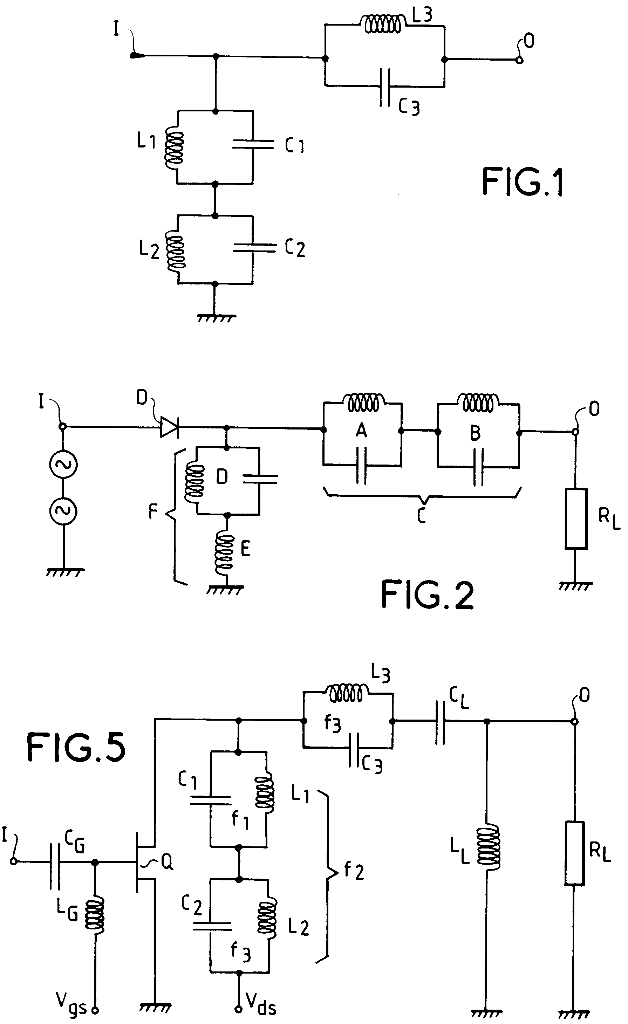

La figure 1 représente un exemple d'étage de sortie selon l'invention. Il est connecté par son entrée I à un circuit électronique tel qu'un amplificateur, ou mélangeur, ou n'importe quel autre type de circuit fournissant un courant dans lequel sont présentes au moins trois fréquences F1, F2 et F3.

Sont connectés en parallèle :
- d'une part au moins un réseau bouchon de type RLC, formé dans l'exemple représenté par une inductance L3 et une capacité C3. Ce réseau est un réseau d'adaptation de réjection à la fréquence F3 et il est monté sur la voie de sortie 0 ;
- d'autre part au moins un réseau de réjection de type RLC, mis à la masse. Dans l'exemple représenté, il comprend un premier réseau L₁ C₁ en série avec un second réseau L₂ C₂.

Ces réseaux sont accordés sur les fréquences F1, F2 et F3, chacun étant considéré séparément. Le fondement de l'invention consiste en ce que :
- le réseau L₁ C₁ participe avec L₂ à l'adaptation à la fréquence F1.
- le réseau L₂ C₂, de même que le réseau L₃ C₃ présente un circuit ouvert à la fréquence F3.
- mais l'ensemble des deux réseaux L₁ C₁ et L₂ C₂ se comporte comme un court-circuit pour la fréquence F2.

Un exemple d'application est donné avec le mélangeur à diode de la figure 2, dans lequel la rotation entre les fréquences n'est pas harmonique. Ce mélangeur reçoit sur son entrée I au moins deux fréquences différentes symbolisées par deux générateurs. On désire isoler sur sa sortie une fréquence intermédiaire, par exemple F3 = 2 GHz, pour laquelle le réseau combiné est adapté, tandis que les réseaux composants sont à réjection de fréquence, par exemple pour l'oscillateur local à F1 = 2,5 GHz et pour la radiofréquence à F2 = 500 MHz = 0,5 GHz.

Le réseau bouchon A présente un circuit ouvert à 0,5 GHz et le réseau bouchon B présente un circuit ouvert à 3 GHz, mais les valeurs des deux réseaux bouchons sont accordées de manière que le réseau C, équivalant à l'ensemble des deux réseaux A et B, fasse un court-circuit à 2 GHz.

De même, le réseau D présente un circuit ouvert à la fréquence 2 GHz, mais associé à une inductance E, il donne un réseau équivalent F qui est un court-circuit pour la fréquence d'oscillateur local 2,5 GHz.

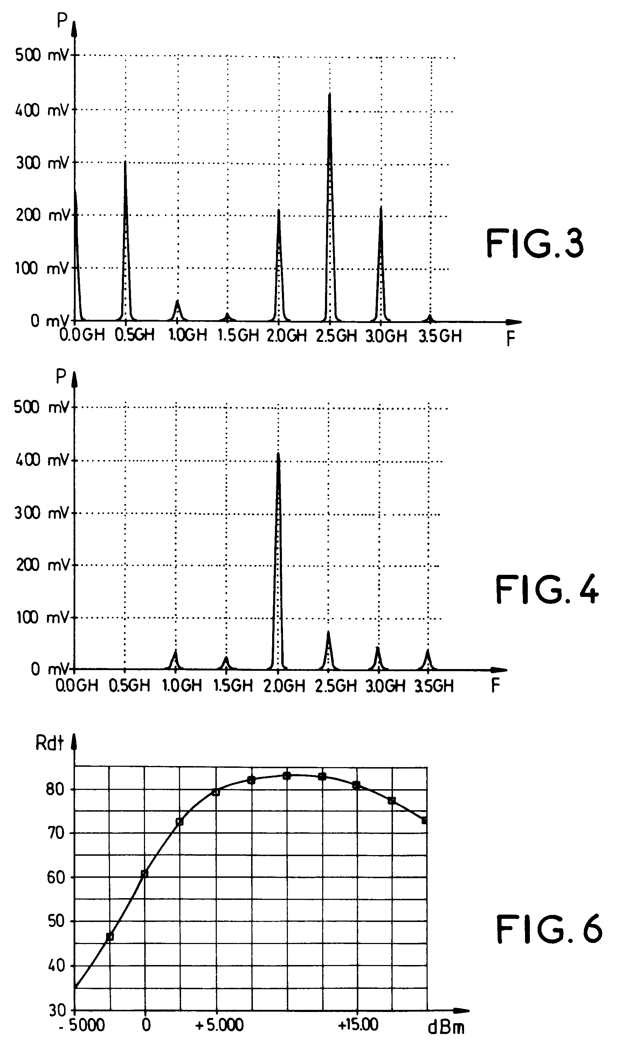

Les figures 3 et 4 montrent l'efficacité de l'étage de sortie selon l'invention. La figure 3 donne le spectre des fréquences présentes sur la sortie 0 d'un mélangeur sans étage de sortie tel que décrit : ce spectre comporte des bandes à 0,5 - 2 - 2,5 et 3 GHz, en abondances presque comparables (valeurs relatives allant du simple au double, 200 à 400 mV en intensité).

Par contre, la figure 4 donne le spectre de sortie pour un mélangeur à diode muni de l'étage de sortie, conformément à la figure 2. La combinaison des réseaux de réjection et d'adaptation supprime toutes les fréquences indésirables autres que celle en sortie 0, qui est égale à 2 GHz, et les valeurs relatives entre les fréquences parasites et la fréquence choisie est de l'ordre de 1 à 8 ou 10.

Un autre exemple d'application est représenté en figure 5 : il s'agit d'un amplificateur de puissance, construit autour d'un transistor à effet de champ Q, convenablement polarisé par V_{gs} et V_{ds}, et pour lequel les fréquences F1 F2 et F3 sont en relation harmonique. L'étage de sortie de cet amplificateur comprend un réseau d'adaptation à la fréquence fondamentale F1 = 1,8 GHz par exemple, avec réjection des fréquences harmonique 2 à F2 et harmonique 3 à F3. On aurait pu choisir un autre exemple de classe de fonctionnement.

Le premier réseau bouchon L₁ C₁, combiné avec C₂, complète l'adaptation à la fréquence fondamentale F1 = 1,8 GHz. Le second réseau bouchon L₂ C₂, d'une part, et le troisième réseau bouchon L₃ C₃ d'autre part présentent un circuit ouvert à l'harmonique 3 F3 = 5,4 GHz.

Mais les réseaux L₁ C₁ et L₂ C₂ ont été calculés pour que leur combinaison se comporte comme un court-circuit pour l'harmonique 2 F2 = 3,6 GHz.

La courbe de la figure 6 présente le rendement en puissance ajoutée obtenue avec cet amplificateur : le rendement, porté en ordonné, est amélioré par rapport à un amplificateur selon l'art connu. On peut également considérer que, pour un rendement donné, le niveau de sortie est meilleur de 3 dB.

L'intérêt de l'étage de sortie selon l'invention est son entière comptabilité avec les étapes de réalisation des filières technologiques micro-ondes, bien que la réalisation de l'étage de sortie par combinaison de réseaux ne soit pas limitative aux seuls exemples présentés, ou à une seule technologie, non plus qu'à des réseaux à éléments distribués ou à éléments localisés.

## Revendications

1. Etage de sortie d'un circuit électronique travaillant à au moins trois fréquences (F1, F2, F3) et comportant au moins un réseau d'adaptation (C₁ L₁L₂) et un réseau de réjection (C₂ L₂), cet étage de sortie étant caractérisé en ce que au moins deux réseaux (C₁ L₁, C₂ L₂) calculés pour correspondre chacun séparément à une fréquence de travail (F1, F3), donnent dans leur combinaison l'équivalent d'un troisième réseau qui correspond à une troisième fréquence (F2).

2. Etage de sortie selon la revendication 1, caractérisé en ce que lesdits réseaux d'adaptation, de type circuit bouchon RLC, sont montés l'un au moins (L₃ C₃) en série sur la sortie (0) d'un circuit électronique, un autre au moins (L₁ C₁) en parallèle sur la sortie dudit circuit.

3. Etage de sortie selon la revendication 1, caractérisé en ce que les trois fréquences (F1 F2 F3) sont en relation harmonique.

4. Etage de sortie selon la revendication 1, caractérisé en ce que les trois fréquences (F1 F2 F3) sont sans relation harmonique.
